# EUROPÄISCHE PATENTSCHRIFT

(11) **EP 0 692 158 B1**
(45) Veröffentlichungstag und Bekanntmachung des Hinweises auf die Patenterteilung: **23.07.1997**
(21) Anmeldenummer: 94912987.8
(22) Anmeldetag: 31.03.1994
(51) Int. Cl.: H03K 17/22, G11C 7/00, G05B 19/02

(54) **EINRICHTUNG FÜR ELEKTRISCHE STEUERUNGEN ZUR RÜCKSTELLUNG VON DIGITALEN UND ANALOGEN SIGNALEN IN ELEKTRONISCHEN BAUTEILEN IN EINEN DEFINIERTEN AUSGANGSZUSTAND NACH EINEM EINSCHALT- ODER EINEM RESETVORGANG**
DEVICE FOR ELECTRICAL CONTROLS FOR RESETTING DIGITAL AND ANALOG SIGNALS IN ELECTRONIC COMPONENTS TO A DEFINED INITIAL STATUS AFTER A SWITCH-ON OR RESET OPERATION
DISPOSITIF POUR COMMANDES ELECTRIQUES PERMETTANT DE REMETTRE DANS UN ETAT INITIAL DEFINI DES SIGNAUX NUMERIQUES OU ANALOGIQUES DANS DES COMPOSANTS ELECTRONIQUES APRES UNE OPERATION DE MISE EN MARCHE OU DE REMISE A ZERO

(30) Priorität: 01.04.1993 AT 664/93; 01.04.1993 AT 665/93
(43) Veröffentlichungstag der Anmeldung: 17.01.1996
(73) Patentinhaber: ELIN ENERGIEANWENDUNG GESELLSCHAFT M.B.H., A-1141 Wien (AT)
(72) Erfinder: HASENBERGER, Ronald, A-1220 Wien (AT)
(74) Vertreter: Krause, Peter
(86) Internationale Anmeldenummer: AT9400036
(87) Internationale Veröffentlichungsnummer: WO9423498

(56) Entgegenhaltungen:
- EP-A- 0 250 242
- EP-A- 0 337 538
- US-A- 4 858 197
- US-A- 5 019 996
- IBM TECHNICAL DISCLOSURE BULLETIN, Bd. 29, Nr. 10., März 1987, Armonk, US, SS. 4569-4572, 'Power-On Reset Circuit'

## Beschreibung

Die Erfindung betrifft eine Einrichtung für elektrische Steuerungen zur Rückstellung von digitalen Signalen in elektronischen Bauteilen in einen definierten Ausgangszustand nach einem Einschalt- oder einem Reset-Vorgang, wobei ein Speicherelement vorgesehen ist, und wobei eine Folgeschaltung einen hochohmigen Zustand des Speicherelementes als inaktiv erkennt, und wobei Bauteile vorgesehen sind, deren Funktionsfähigkeit ab jener Spannung gegeben ist, bei der die Folgeschaltung frühestens auf ein aktives Ausgangssignal reagiert, und wobei ein gültiges Reset ab jener Spannung erfolgt, bei der die Folgeschaltung frühestens auf ein aktives Ausgangssignal reagiert, sowie weiters eine Einrichtung für elektrische Steuerungen zur Rückstellung von analogen Signalen in elektronischen Bauteilen in einen definierten Ausgangszustand nach einem Einschalt- oder einem Reset-Vorgang, wobei ein multiplizierender Digital/Analog-Konverter als Speicherelement vorgesehen ist, und wobei Bauteile vorgesehen sind, deren Funktionsfähigkeit ab jener Spannung gegeben ist, bei der eine Folgeschaltung frühestens auf ein aktives Ausgangssignal reagiert, und wobei der Fail Safe-Zustand der Folgeschaltung Null Volt ist, und wobei ein gültiges Reset ab jener Spannung erfolgt, bei der die Folgeschaltung frühestens auf ein aktives Ausgangssignal reagiert.

In der Mikroprozessortechnik existiert bei Steuerungen die unangenehme Situation, daß nach dem Einschalten, aber auch nach einem Reset (beispielsweise durch Abfallen eines Watchdogs), die Zustände der Ausgänge nicht definiert sind. Fällt der Watchdog ab, ist der Zustand der Ausgänge zwar definiert; obwohl für das Abfallen ein Grund - üblicherweise ein nicht korrektes Funktionieren der Software - vorhanden war, ist jedoch nicht sichergestellt, daß der damit bewirkte Zustand der Ausgänge sinnvoll ist.

Ursache dieser mangelnden Definition ist der Umstand, daß in sämtlichen Speicherelementen nach dem Einschalten ein zufälliger Wert steht. Dies kann unter Umständen zu gefährlichen Situationen in der Umgebung der jeweiligen Schaltung führen.

Es ist eine Methode bekannt, mit welcher die Lösung dieses Problems durch Unterbrechung der Ausgangsspannung für das Speicherelement mittels eines Relaiskontaktes versucht wird.

Der Nachteil dieser Methode besteht in der langsamen Ansprechzeit eines Relais sowie in dessen Störanfälligkeit und den im Vergleich zu elektronischen Bauteilen sehr hohen Kosten.

Eine andere Methode besteht darin, daß die jeweilige Gültigkeit der Daten auf den Signalleitungen durch eine zusätzliche Signalleitung angezeigt wird.

Diese Methode ist nachteilig, weil der zur Auswertung der zusätzlichen Signalleitung benötigte Aufwand der Folgeschaltung sehr hoch ist.

Die Patentpublikation EP-A-0 337 538 befaßt sich mit einem integrierten Schaltkreis, welcher eine Logikschaltung und einen logischen Ausgabepufferspeicher aufweist. Der integrierte Schaltkreis umfaßt als Teilschaltkreise einen Speicherkreis sowie einen logischen Ausgabekreis, in welchen bei der Ausgabe kein "Tristate-Logikzustand" während der Zeitabfolge der Datensignale bei der Eingabe erfolgt. Die Ansteuerung des Schaltkreises mittels Steuersignalen ist unkritisch, weil das erste Datensignal der Abfolge den Tristate-Modus abschaltet. Der Tristate-Modus wird dann wieder aktiviert, wenn ein Steuersignal abgesetzt wird. Beim Ausbleiben dieses Steuersignales wird das letzte Datensignal aufrecherhalten. Konkret beschäftigt sich diese Patentpublikation also mit einer Einrichtung, welche auf einem Bus Daten speichert, wobei die Bussignale differentiell, also in invertierter und in nichtinvertierter Form verfügbar sind. Es werden die zwei Leitungen im Prinzip für die Darstellung eines ternären (dreiwertigen) Signals verwendet: Beide Signale 0 entspricht keiner Änderung; eine Leitung 0, die andere 1 entspricht dem entsprechenden Zustand (low bzw. high) für das Datenpaar. Beide Leitungen 1 ist in dieser Schaltung ein ungültiger Zustand, was sich durch die Verwendung eines RS-Flipflops ergibt. Mit dem Aktivwerden eines Signals (d. h. entweder die invertierte oder die nichtinvertierte Leitung des Datenpaares wird high) wird der Ausgang vom hochohmigen in den niederohmigen Zustand geschaltet; der Ausgang verbleibt im niederohmigen Zustand, wenn dieser Zustand schon vorher gegeben war. Durch die OE-Leitung besteht eine Möglichkeit, die Ausgangstreiber in den hochohmigen Zustand zu bringen. Die eigentliche Absicht der Erfindung lt. Patentpublikation EP-A-0 337 538 ist somit ein "intelligenter" Treiber, der Signale möglichst schnell durchschaltet und den alten Signalpegel aufrecht erhält, wenn das Signal selbst wieder verschwunden ist (d.h. wenn sowohl die invertierte als auch nichtinvertierte Leitung inaktiv, also im Low-Zustand sind).

Nachteilig an der in der Patentpublikation EP-A-0 337 538 beschriebenen Erfindung ist, daß die vorgeschlagene Methode nur in integrierten Schaltungen sinnvoll anwendbar ist; es wird die Verfügbarkeit von differentiellen Daten vorausgesetzt. Die in einer Mikroprozessor-Umgebung im allgemeinen vorhandene Ressourcen - also beispielsweise Reset- und Schreib-Signal - werden hier nicht ausgenützt. Zudem sind sehr aufwendige und breite ODER-Gatter dazu erforderlich.

Aufgabe der Erfindung ist es, universelle Lösungen zur Rückstellung von digitalen Signalen, sowie zur Rückstellung von analogen Signalen in elektronischen Bauteilen zu konzipieren, welche es ermöglichen, das Setzen der Steuerungsausgänge unter Ausschaltung der Nachteile der bekannten Methode sowie mit großer Betriebssicherheit zu gewährleisten.

Die Aufgabe wird durch die Erfindung gelöst. Die erfindungsgemäße Einrichtung ist in ihrer Ausbildung zur Rückstellung digitaler Signale dadurch gekennzeichnet, daß ein als Flipflop ausgeführtes Zwischenglied vorgesehen ist, und daß jedes auf das Speicherelement bezogene Reset dem Zwischenglied zugeleitet ist, und daß ein Setzen des Zwischengliedes gleichzeitig mit dem einem Reset folgenden, jeweils ersten Schreibvorgang auf das Speicherelement erfolgt, und daß ein Output Enable-Signal von einem Ausgang des Zwischengliedes einem OE-Eingang des Speicherelementes zuführbar ist.

Die Erfindung ist vorteilhaft, weil durch die Vermeidung nicht vorhersehbarer Ausgangszustände automatische Steuerungen stabilisierbar sind. Ein weiterer Vorteil ist die einfache Ausführung, welche keinen zusätzlichen Aufwand in der Folgeschaltung erfordert.

In einer Weiterbildung der Erfindung ist das Zwischenglied als RS-Flipflop ausgeführt, und jedes auf das Ausgabeelement bezogene Reset ist dem R-Eingang des Zwischengliedes zugeleitet, und die WRITE-Signale sind dem S-Eingang des Zwischengliedes zugeleitet.

Diese Weiterbildung ist vorteilhaft, weil RS-Flipflops sehr einfach aus Restgattern aufgebaut werden können.

In einer Ausgestaltung der Erfindung ist vorgesehen, daß das Zwischenglied als D-Flipflop ausgeführt ist, und daß jedes auf das Speicherelement bezogene Reset dem Rücksetzeingang des Zwischengliedes zugeleitet ist.

Der Vorteil dieser Ausgestaltung besteht darin, daß der Ausgang erst dann freigegeben wird, wenn der Schreibvorgang abgeschlossen ist.

In einer Weiterbildung der Erfindung ist vorgesehen, daß bei der erfindungsgemäßen Einrichtung in ihrer Ausbildung zur Rückstellung von analogen Signalen ein als Flipflop ausgeführtes Zwischenglied vorgesehen ist, und daß jedes auf das Speicherelement bezogene Reset dem Zwischenglied zugeleitet ist, und daß ein Setzen des Zwischengliedes gleichzeitig mit dem einem Reset folgenden, jeweils ersten Schreibvorgang auf das Speicherelement erfolgt, und daß die Referenzspannung für das Speicherelement dem nichtinvertierenden Eingang eines Operationsverstärkers zugeführt ist, dessen Ausgang mit dem Referenzeingang des Speicherelementes verbunden ist, und daß ein Ausgang des Zwischengliedes sowie der invertierende Eingang des Operationsverstärkers und der Referenzeingang des Speicherelementes über einen Feldeffekt-Transistor auf einen gemeinsamen Massepunkt geschaltet sind, wobei der Ausgang des Zwischengliedes mit dem Gate-Anschluß, und der invertierende Eingang des Operationsverstärkers sowie der Referenzeingang des Speicherelementes mit dem Drain-Anschluß, und der Massepunkt mit dem Source-Anschluß verbunden ist.

Die erfindungsgemäße Einrichtung ist auch in ihrer Ausbildung zur Rückstellung analoger Signale deswegen vorteilhaft, weil durch die Vermeidung nicht vorhersehbarer Ausgangszustände automatische Steuerungen stabilisierbar sind. Auch hier erfordert die relativ einfache Ausführung keine Folgeschaltung als zusätzlichen Aufwand.

Eine Weiterbildung der Erfindung sieht vor, daß das Zwischenglied als RS-Flipflop ausgeführt ist, und daß jedes auf das Speicherelement bezogene Reset dem R-Eingang des Zwischengliedes zugeleitet ist, und daß die WRITE-Signale dem S-Eingang des Zwischengliedes zugeleitet sind.

Auch diese Weiterbildung ist vorteilhaft, weil RS-Flipflops sehr einfach aus Restgattern aufgebaut werden können.

In einer Ausgestaltung der Erfindung ist das Zwischenglied als D-Flipflop ausgeführt, und jedes auf das Speicherelement bezogene Reset ist dem Rücksetzeingang des Zwischengliedes zugeleitet.

Der Vorteil dieser Ausgestaltung besteht - identisch wie bei der Ausbildung für digitale Signale - darin, daß der Ausgang erst dann freigegeben wird, wenn der Schreibvorgang abgeschlossen ist.

In einer erfindungsgemäßen Weiterbildung ist vorgesehen, daß zwischen dem Ausgang des Operationsverstärkers und dem Referenzeingang des Speicherelementes ein Widerstand angeordnet ist, der einen Widerstandswert aufweist, welcher beim kleinstmöglichen Eingangswiderstand in den Referenzeingang gerade noch in der Lage ist, die Referenzspannung sicher aufrecht zu erhalten.

Der Vorteil dieser Weiterbildung besteht in einer Minimierung der Verluste des Verstärkers während des "Abdrehens" der Referenzspannung.

In einer zusätzlichen Ausgestaltung der Erfindung weist der Feldeffekt-Transistor eine Treshhold-Spannung auf, welche kleiner ist als jene Spannung, bei der die Folgeschaltung frühestens auf ein Ausgangssignal reagiert.

Dadurch ist es möglich, die Sicherheit bei der Datenübertragung zu erhöhen.

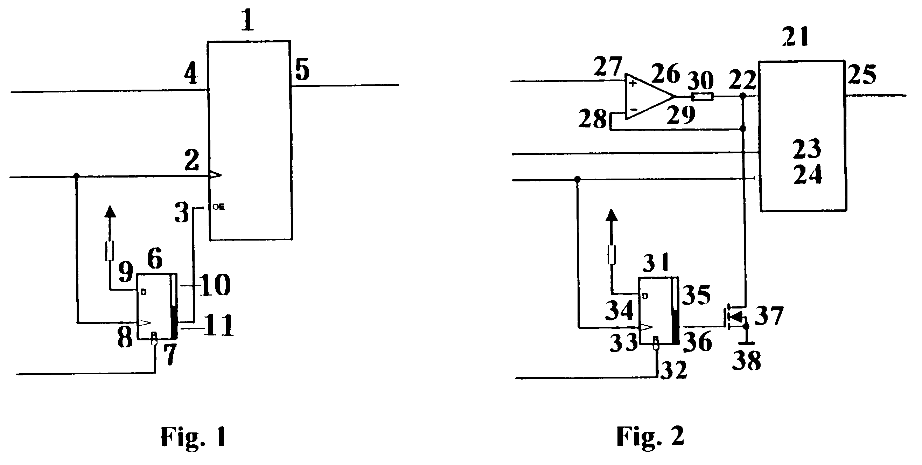

Anhand von Ausführungsbeispielen soll die Erfindung näher erläutert werden, wobei in Fig. 1 die erfindungsgemäße Einrichtung in ihrer Ausbildung zur Rückstellung digitaler Signale, und in Fig. 2 in ihrer Ausbildung zur Rückstellung analoger Signale dargestellt ist.

Fig. 1 zeigt ein Speicherelement 1, welches als getaktetes Flipflop mit Dateneingang 4, Datenausgang 5, Takteingang 2 und negierendem OE-Eingang 3 ausgeführt ist. Ein getaktetes D-Flipflop dient als Zwischenglied 6. Es weist eine festgelegte Grundstellung auf, wodurch bei Ruhelage der erste Ausgang 10 den Zustand Null, und der zweite Ausgang 11 den Zustand 1 aufweist. Weitere Anschlüsse des Zwischengliedes 6 sind ein D-Eingang 9, ein Takteingang 8 sowie ein Rücksetzeingang 7. Der negierende OE-Eingang 3 des Speicherelementes 1 ist mit dem zweiten Ausgang 11 des Zwischengliedes 6 verbunden.

Ausgehend von der Annahme, daß zweckmäßige Werte frühestens nach dem ersten Schreiben auf das Speicherelement 1 vorliegen, ist es sinnvoll, die Freigabe des Ausgangs 5 mit dem Schreiben auf das Speicherelement 1 zu verbinden. Erfindungsgemäß wird das Zwischenglied 6 zurückgesetzt, sobald Reset kommt, und erst nach dem ersten Schreibvorgang auf das Speicherelement 1 gesetzt und somit die Ausgabe freigegeben. Da das Zwischenglied 6 gleichzeitig mit dem Speichern des aktuellen Datenwertes im Speicherelement 1 gesetzt wird, wird nie ein ungültiger Zustand ausgegeben. In der Fig. ist eine variable Wortbreite (w+1) angegeben, da diese Spezialität von der Entwicklung unabhängig ist und im Prinzip nur durch die Datenwortbreite des jeweiligen Prozessors und die Breite des eingesetzten Speicherelementes bestimmt wird.

Voraussetzungen für das Funktionieren der Erfindung sind: ein gültiges Reset ab jener Spannung, bei der die Folgeschaltung frühestens auf ein aktives Ausgangssignal reagieren kann; grundsätzliche Funktionsfähigkeit aller Bauteile ab jener Spannung, bei der die Folgeschaltung frühestens auf ein aktives Ausgangssignal reagieren kann; die Folgeschaltung muß einen hochohmigen Zustand des Speicherelementes 1 als inaktiv erkennen. Diese Anforderungen können beispielsweise durch Optokoppler als Folgeschaltung erfüllt werden.

Fig. 2 zeigt ein Speicherelement 21, welches als multiplizierender Digital/Analog-Konverter mit Referenzeingang 22, Dateneingang 23, negierendem WRITE-Eingang 24 sowie Datenausgang 25 ausgeführt ist. Ein getaktetes D-Flipflop dient als Zwischenglied 31. Es weist eine festgelegte Grundstellung auf, wodurch bei Ruhelage der erste Ausgang 35 den Zustand Null, und der zweite Ausgang 36 den Zustand 1 hat. Weitere Anschlüsse des Zwischengliedes 31 sind ein D-Eingang 34, ein Takteingang 33 sowie ein Rücksetzeingang 32. Die Referenzspannung für das Speicherelement 21 wird dem nichtinvertierenden Eingang 27 eines Operationsverstärkers 26 zugeführt, dessen Ausgang 29 über einen Widerstand 19 mit dem Referenzeingang 22 des Speicherelementes 21 verbunden ist. Der Widerstand 30 weist einen Widerstandswert auf, welcher beim kleinstmöglichen Eingangswiderstand in den Referenzeingang 22 gerade noch in der Lage ist, die Referenzspannung sicher aufrecht zu erhalten. Der zweite Ausgang 36 des Zwischengliedes 31 sowie der invertierende Eingang 28 des Operationsverstärkers 26 und der Referenzeingang 22 des Speicherelementes 21 sind über einen Feldeffekt-Transistor 37 auf einen gemeinsamen Massepunkt 38 geschaltet. Die Treshhold-Spannung des Feldeffekt-Transistors 37 muß kleiner sein als jene Spannung, bei der die Folgeschaltung frühestens auf ein Ausgangssignal reagiert. Konkret ist der zweite Ausgang 36 des Zwischengliedes 31 mit dem Gate-Anschluß, und der invertierende Eingang 28 des Operationsverstärkers 26 sowie der Referenzeingang 22 des Speicherelementes 21 mit dem Drain-Anschluß, und der Massepunkt 38 mit dem Source-Anschluß verbunden.

Ausgehend von der Annahme, daß zweckmäßige Werte frühestens nach dem ersten Schreiben auf das Speicherelement 21 vorliegen, ist es sinnvoll, die Freigabe des Ausgangs 25 mit dem Schreiben auf das Speicherelement 21 zu verbinden. Erfindungsgemäß wird das Zwischenglied 31 zurückgesetzt, sobald Reset kommt, und erst nach dem ersten Schreibvorgang auf das Speicherelement 21 gesetzt und somit die Ausgabe freigegeben. Da das Zwischenglied 26 gleichzeitig mit dem Speichern des aktuellen Datenwertes im Speicherelement 21 gesetzt wird, wird nie ein ungültiger Zustand ausgegeben.
Die Sperre des Ausgangs 25 des als multiplizierenden Digital/Analog-Konverter ausgeführten Speicherelementes 21 erfolgt durch "Abdrehen" von dessen Referenzspannung. Da multiplizierende Digital/Analog-Konverter - diese sind Standard - am Ausgang eine Spannung REFIN*D(0:w) ausgeben, werden damit, unabhängig vom gespeicherten Datenwort D(0:w), Null Volt ausgegeben.
Um das "Abdrehen" der Referenzspannung zu ermöglichen, erfolgt eine spezielle Aufarbeitung der Referenzspannung mit einem Operationsverstärker 26, dessen Ausgangswiderstand mittels eines Widerstandes 30 künstlich erhöht ist. Die Dimensionierung des Widerstandes 30 hat dabei so zu erfolgen, daß beim kleinstmöglichen Eingangswiderstand in den Referenzeingang 22 (also bei größtmöglichem Strom) der Operationsverstärker 26 gerade noch in der Lage ist, die Referenzspannung sicher aufrecht zu erhalten. Damit ist sichergestellt, daß während des "Abdrehens" der Referenzspannung nicht unnötig viel Strom vom Operationsverstärker 26 geliefert werden muß.

Voraussetzungen für das Funktionieren der Erfindung sind: ein gültiges Reset ab jener Spannung, bei der die Folgeschaltung frühestens auf ein Ausgangssignal reagieren kann; grundsätzliche Funktionsfähigkeit aller Bauteile ab jener Spannung, bei der die Folgeschaltung frühestens auf ein Ausgangssignal reagieren kann; Null Volt muß der Fail safe-Zustand der Folgeschaltung sein.

## Patentansprüche

1. Einrichtung für elektrische Steuerungen zur Rückstellung von digitalen Signalen in elektronischen Bauteilen in einen definierten Ausgangszustand nach einem Einschalt- oder einem Reset-Vorgang, wobei ein Speicherelement vorgesehen ist, und wobei eine Folgeschaltung einen hochohmigen Zustand des Speicherelementes als inaktiv erkennt, und wobei Bauteile vorgesehen sind, deren Funktionsfähigkeit ab jener Spannung gegeben ist, bei der die Folgeschaltung frühestens auf ein aktives Ausgangssignal reagiert, und wobei ein gültiges Reset ab jener Spannung erfolgt, bei der die Folgeschaltung frühestens auf ein aktives Ausgangssignal reagiert, **dadurch gekennzeichnet,** daß ein als Flipflop ausgeführtes Zwischenglied (6) vorgesehen ist, und daß jedes auf das Speicherelement (1) bezogene Reset dem Zwischenglied (6) zugeleitet ist, und daß ein Setzen des Zwischengliedes (6) gleichzeitig mit dem einem Reset folgenden, jeweils ersten Schreibvorgang auf das Speicherelement (1) erfolgt, und daß ein Output Enable-Signal von einem Ausgang des Zwischengliedes (6) einem OE-Eingang (3) des Speicherelementes (1) zuführbar ist.

2. Einrichtung nach Anspruch 1, **dadurch gekennzeichnet,** daß das Zwischenglied als RS-Flipflop ausgeführt ist, und daß jedes auf das Ausgabeelement bezogene Reset dem R-Eingang des Zwischengliedes zugeleitet ist, und daß die WRITE-Signale dem S-Eingang des Zwischengliedes zugeleitet sind.

3. Einrichtung nach Anspruch 1, **dadurch gekennzeichnet,** daß das Zwischenglied (6) als D-Flipflop ausgeführt ist, und daß jedes auf das Speicherelement (1) bezogene Reset dem Rücksetzeingang (7) des Zwischengliedes (6) zugeleitet ist. (Fig. 1)

4. Einrichtung für elektrische Steuerungen zur Rückstellung von analogen Signalen in elektronischen Bauteilen in einen definierten Ausgangszustand nach einem Einschalt- oder einem Reset-Vorgang, wobei ein multiplizierender Digital/Analog-Konverter als Speicherelement vorgesehen ist, und wobei Bauteile vorgesehen sind, deren Funktionsfähigkeit ab jener Spannung gegeben ist, bei der eine Folgeschaltung frühestens auf ein aktives Ausgangssignal reagiert, und wobei der Fail Safe-Zustand der Folgeschaltung Null Volt ist, und wobei ein gültiges Reset ab jener Spannung erfolgt, bei der die Folgeschaltung frühestens auf ein aktives Ausgangssignal reagiert, **dadurch gekennzeichnet,** daß ein als Flipflop ausgeführtes Zwischenglied (31) vorgesehen ist, und daß jedes auf das Speicherelement (21) bezogene Reset dem Zwischenglied (31) zugeleitet ist, und daß ein Setzen des Zwischengliedes (31) gleichzeitig mit dem einem Reset folgenden, jeweils ersten Schreibvorgang auf das Speicherelement (21) erfolgt, und daß die Referenzspannung für das Speicherelement (21) dem nichtinvertierenden Eingang (27) eines Operationsverstärkers (26) zugeführt ist und dessen Ausgang (29) mit dem Referenzeingang (22) des Speicherelementes (21) verbunden ist, und daß ein Ausgang des Zwischengliedes (31) sowie der invertierende Eingang (28) des Operationsverstärkers (26) und der Referenzeingang (22) des Speicherelementes (21) über einen Feldeffekt-Transistor (37) auf einen gemeinsamen Massepunkt (38) geschaltet sind, wobei der Ausgang des Zwischengliedes (31) mit dem Gate-Anschluß, und der invertierende Eingang (28) des Operationsverstärkers (26) sowie der Referenzeingang (22) des Speicherelementes (21) mit dem Drain-Anschluß, und der Massepunkt (38) mit dem Source-Anschluß verbunden ist.

5. Einrichtung nach Anspruch 4, **dadurch gekennzeichnet,** daß das Zwischenglied (31) als RS-Flipflop ausgeführt ist, und daß jedes auf das Speicherelement (21) bezogene Reset dem R-Eingang des Zwischengliedes (31) zugeleitet ist, und daß die WRITE-Signale dem S-Eingang des Zwischengliedes (31) zugeleitet sind.

6. Einrichtung nach Anspruch 4, **dadurch gekennzeichnet,** daß das Zwischenglied (31) als D-Flipflop ausgeführt ist, und daß jedes auf das Speicherelement (21) bezogene Reset dem Rücksetzeingang (31) des Zwischengliedes (31) zugeleitet ist. (Fig. 2)

7. Einrichtung nach Anspruch 4, 5 und 6, **dadurch gekennzeichnet,** daß zwischen dem Ausgang (29) des Operationsverstärkers (26) und dem Referenzeingang (22) des Speicherelementes (21) ein Widerstand (30) angeordnet ist, der einen Widerstandswert aufweist, welcher beim kleinstmöglichen Eingangswiderstand in den Referenzeingang (22) gerade noch in der Lage ist, die Referenzspannung sicher aufrecht zu erhalten.

8. Einrichtung nach Anspruch 4, 5, 6 und 7, **dadurch gekennzeichnet,** daß der Feldeffekt-Transistor (37) eine Treshhold-Spannung aufweist, welche kleiner ist als jene Spannung, bei der die Folgeschaltung frühestens auf ein Ausgangssignal reagiert.

## Claims

1. An electric control device for putting digital signals into a predetermined reset condition in electronic components, following a reset or switch-on operation, where a memory element is provided and a sequential circuit identifies a strongly ohmic condition of said memory element as an inactive one and where components are provided, the working capability of which is given from the voltage at which said sequential circuit at the earliest reacts to an active initial signal, and where a valid resetting operation takes place for the voltage at which said sequential circuit at the earliest reacts to an active initial signal, characterized in that an intermediate member (9) is provided, in the form of a flipflop circuit, and in that each resetting operation, relating to said memory element (1), is conveyed to said intermediate member (6) and that a setting operation of said intermediate member (6) is carried out, simultaneously to the respective first writing operation following a resetting operation, which writing operation concerns said memory element (1), and in that an output enabling signal is apt to be forwarded from said intermediate member (6) to an output enabling input of said memory element (1).

2. The device as recited in claim 1, characterized in that said intermediate member is designed in the form of a RS-flipflop, and in that each resetting operation relative to the emitter element is applied to R-input of said intermediate member, and in that WRITE signals are applied to S-input of said intermediate member.

3. The device as recited in claim 1, characterized in that said intermediate member (6) is designed as a D-flipflop, and in that each resetting operation concerning said memory element (1) is applied to the resetting input (7) of said intermediate member (6) (figure 1).

4. An electric control device for putting digital signals into a predetermined reset condition in electronic components, following a reset or switch-on operation, with a multiplier digital-to-analog converter being provided as a memory element and components being provided, the working capability of which is given from the voltage at which a sequential circuit at the earliest reacts to an active initial signal, and where the integrated safety condition of said sequential circuit is the voltage equal to zero volt and where a valid resetting operation takes place from the voltage at which said sequential circuit at the earliest reacts to an active initial signal, characterized in that an intermediate member (31) is provided, in the form of a flipflop-circuit, and in that each resetting operation relating to said memory element (21) is conveyed to said intermediate member (31), and in that a setting operation or said intermediate member (31) is carried out, simultaneously to the first writing operation in said memory element (21), each time following a resetting operation, and in that the reference voltage for said memory element (21) is applied to the non-reverse input (27) of an operational amplifier (26) the output (29) of which is connected to the reference input (22) of said memory element (21), and in that an output of said intermediate member (31) as well as the reverse input (28) of said operational amplifier (26) and the rererence input (22) of said memory element (21) are connected, through a field effect transistor (37), to a common ground (38), the output of said intermediate member (31) being connected to the grid junction, and the reverse input (28) of said operational amplifier (26) as well as the reference input (22) of said memory element (21) being connected to the drain junction and the ground (38) being connected to the source junction.

5. The device as recited in claim 4, characterized in that said intermediate member (31) is designed in the form of a RS-flipflop, and in that each resetting operation, concerning said memory element (21), is applied to the R-input of said intermediate member (31), and in that the WRITE signals are applied to the S-input of said intermediate member (31).

6. The device as recited in claim 4, characterized in that said intermediate member (31) is designed as a D-flipflop, and in that each resetting operation concerning said memory element (21) is applied to the reset input (31) of said intermediate member (31) (Figure 2).

7. The device as recited in claims 4, 5 and 6 characterized in that, between output (29) of said operational amplifier (26) and reference input (22) of said memory element (21), a resistor (30) is disposed, the ohmic resistance of which is still apt to surely maintain the reference voltage when input resistance in reference input (22) shows a minimum value.

8. The device as recited in claims 4, 5, 6 and 7, characterized in that said field effect transistor (37) has a threshold voltage lower than the voltage at which the switching circuit at the earliest reacts to an initial signal.

## Revendications

1. Dispositif pour commandes électriques permettant de remettre dans un état initial défini des signaux numériques dans des composants électroniques, après une opération de mise en marche de remise à zéro, où est prévu un élément mémoire, et où un circuit séquentiel identifie un état fortement ohmique de l'élément mémoire comme étant inactif et où sont prévus des composants, dont l'aptitude au fonctionnement est offerte à partir de la tension pour laquelle le circuit séquentiel réagit au plus tôt à un signal initial actif, et où une remise à zéro valide s'effectue pour la tension pour laquelle le circuit séquentiel réagit au plus tôt à un signal initial actif, caractérisé en ce qu'il est prévu un organe intermédiaire (9), réalisé sous la forme de bascule, et en ce que chaque remise à zéro, afférente à l'élément mémoire (1), est amenée à l'organe intermédiaire (6) et qu'une fixation de l'organe intermédiaire (6) s'effectue, simultanément à la première opération d'écriture respective, suivant une remise à zéro, opération faite sur l'élément mémoire (1), et en ce qu'un signal de validation de sortie est susceptible d'être amené d'une sortie de l'organe intermédiaire (6) à une entrée de validation de sortie de l'élément mémoire (1).

2. Dispositif selon la revendication 1, caractérisé en ce que l'organe intermédiaire est réalisé sous forme de bascule RS, et en ce que chaque remise à zéro afférente à l'élément émetteur est amenée à l'entrée R de l'organe intermédiaire, et en ce que les signaux ECRITURE sont amenés à l'entrée S de l'organe intermédiaire.

3. Dispositif selon la revendication 1, caractérisé en ce que l'organe intermédiaire (6) est réalisé sous forme de bascule D, et en ce que chaque remise à zéro afférente à l'élément mémoire (1) est amenée à l'entrée de remise à zéro (7) de l'organe intermédiaire (6) (figure 1).

4. Dispositif pour commandes électriques permettant de remettre dans un état initial défini des signaux analogiques dans des composants électroniques, après une opération de mise en marche ou de remise à zéro, un convertisseur numérique/analogique multiplicateur étant prévu à titre d'élément mémoire et étant prévus des composants, dont l'aptitude au fonctionnement est fournie à partir de la tension pour laquelle un circuit séquentiel réagit au plus tôt à un signal initial actif, et où l'état à sécurité intégré du circuit séquentiel est la tension zéro Volt et où une remise à zéro valide s'effectue à partir de la tension pour laquelle le circuit séquentiel réagit au plus tôt à un signal initial actif, caractérisé en ce qu'est prévu un organe intermédiaire (31) réalisé sous la forme de bascule, et en ce que chaque remise à zéro afférente à l'élément mémoire (21) est amenée à l'organe intermédiaire (31), et en ce qu'une fixation de l'organe intermédiaire (31) s'effectue, simultanément à la première opération d'écriture faite sur l'élément mémoire (21), suivant chaque fois une remise à zéro, et en ce que la tension de référence destinée à l'élément mémoire (21) est amenée à l'entrée non inversive (27) d'un amplificateur opérationnel (26) dont la sortie (29) est reliée à l'entrée de référence (22) de l'élément mémoire (21), et en ce qu'une sortie de l'organe intermédiaire (31) ainsi que l'entrée inversive (28) de l'amplificateur opérationnel (26) et l'entrée de référence (22) de l'élément mémoire (21) sont branchées, par l'intermédiaire d'un transistor à effet de champ (37), sur un point de masse (38) commun, la sortie de l'organe intermédiaire (31) étant reliée au raccordement de grille et l'entrée inversive (28) de l'amplificateur opérationnel (26), ainsi que l'entrée de référence (22) de l'élément mémoire (21), étant reliées au raccordement de drain et le point de masse (38) étant relié au raccordement de source.

5. Dispositif selon la revendication 4, caractérisé en ce que l'organe intermédiaire (31) est réalisé sous forme de bascule RS, et en ce que chaque remise à zéro, afférente à l'élément mémoire (21), est amenée à l'entrée R de l'organe intermédiaire (31), et en ce que les signaux ÉCRITURE sont amenés à l'entrée S de l'organe intermédiaire (31).

6. Dispositif selon la revendication 4, caractérisé en ce que l'organe intermédiaire (31) est réalisé sous forme de bascule D, et en ce que chaque remise à zéro afférente à l'élément mémoire (21) est amenée à l'entrée de remise à zéro (31) de l'organe intermédiaire (31) (figure 2).

7. Dispositif selon les revendications 4, 5 et 6, caractérisé en ce que, entre la sortie (29) de l'amplificateur opérationnel (26) et l'entrée de référence (22) de l'élément mémoire (21), est disposée une résistance (30) qui présente une valeur ohmique qui, lorsque l'on a la résistance d'entrée minimale dans l'entrée de référence (22), est justement encore en mesure de conserver de façon sûre la tension de référence.

8. Dispositif selon les revendications 4, 5, 6 et 7, caractérisé en ce que le transistor à effet de champ (37) présente une tension de seuil inférieure à la tension pour laquelle le circuit de commutation réagit au plus tôt à un signal initial.
